Europäisches Patentamt

European Patent Office

Office européen des brevets

(11) Veröffentlichungsnummer: **0 010 125**
A1

## EUROPÄISCHE PATENTANMELDUNG

(21) Anmeldenummer: 79102810.3

(22) Anmeldetag: 04.08.79

(51) Int. Cl.³: **H 01 L 27/22**
**H 01 L 43/06**

(30) Priorität: 12.10.78 DE 2844420

(43) Veröffentlichungstag der Anmeldung:
30.04.80 Patentblatt 80/9

(84) Benannte Vertragsstaaten:
DE FR GB IT NL

(71) Anmelder: Deutsche ITT Industries GmbH
Hans-Bunte-Strasse 19 Postfach 840
D-7800 Freiburg(DE)

(72) Erfinder: Schwabe, Gerhard
Gilgenmatten 12
D-7800 Freiburg(DE)

(74) Vertreter: Stutzer, Gerhard, Dr.
Deutsche ITT Industries GmbH Patent- und
Linzenabteilung Hans-Bunte-Strasse 19 Postfach 840
D-7800 Freiburg(DE)

(54) Integriertes Hall-Bauelement.

(57) Innerhalb einer monolithisch integrierten Schaltung mit einer Schicht des einen Leitungstyps auf einem plattenförmigen Substratkörper des anderen Leitungstyps integrierbares Hall-Element (3), das ein Paar von Stromeinspeisungskontakten (4), (5) und ein Paar von Hallspannungskontakten aufweist (15), (16). Die Hall-Empfindlichkeit wird dadurch erhöht, daß in Serie zu den Stromeinspeisungskontakten eine Stromquellenschaltung liegt, deren strombestimmender Widerstand (R) aus dem gleichen Halbleitermaterial und der gleichen Dotierung besteht wie das Material des Hall-Elements (3).

Fig 1

EP 0 010 125 A1

G. Schwabe - 6

Fl 978
Go/kn
16. Juli 1979

Integriertes Hall-Bauelement

Aus der DE-OS 19 42 810 ist ein integriertes Hall-Bauelement bekannt, bei dem ein Teil eines Halbleiterkörpers als Hall-Element wirksam ist und der restliche Teil eine Verstärkerschaltung aufnimmt.

Bei der Massenherstellung solcher Hall-Bauelemente ist die Hall-Empfindlichkeit

$$(1) \quad \vec{U}_H = \frac{1}{n \cdot q} \cdot \frac{\vec{I} \cdot \vec{B}}{d}$$

mit n = Dotierungskonzentration
q = Elementarladung
d = Dicke des Hall-Elements
$\vec{I}$ = Hallstrom und
$\vec{B}$ = magnetische Induktion

Diese Hall-Empfindlichkeit ist bei der Massenfertigung von Bauelementen den Schwankungen der Herstellungsbedingungen unterworfen. Man hat daher bereits zusammen mit dem Hall-Element in einem Halbleiterkörper eine Spannungsstabilisierungsschaltung zur Stabilisierung des Hallstroms integriert, so daß die Hall-Empfindlichkeit nach einer einfachen Rechnung

$$(2) \quad \vec{U}_H = \frac{\vec{U} \cdot \vec{B} \cdot \mu}{V} \quad \text{wird}$$

G. Schwabe - 6                                      Fl 978

mit $\mu$ = Beweglichkeit der Ladungsträger

v = Abmessungsfaktor entsprechend dem Längen/Breiten-
Verhältnis des Hall-Elements (v = 1 für eine
quadratische Abmessung)

$\vec{U}$ = anliegende Spannung

Doch auch die Empfindlichkeit eines solchen integrierten
Hall-Bauelements ist in gleicher Weise den Schwankungen der
Herstellungsbedingungen unterworfen, da sowohl der Widerstand des Hall-Elements als auch die Ausgangsspannung der
erforderlichen integrierten Spannungsregelschaltung von
diesen Schwankungen abhängig ist.

Aus der DE-OS 26 52 322 ist ein Hall-Element bekannt,
welches aus einem Bereich einer Epitaxschicht des einen
Leitungstyps auf einem plattenförmigen Substratkörper des
anderen Leitungstyps besteht und sowohl ein Paar von Stromeinspeisungskontakten  als auch ein Paar von Hallspannungskontakten aufweist. Da ein solches Hall-Element besonders
gut zur Aufnahme einer integrierten Schaltung geeignet ist,
geht die Erfindung von diesem bekannten Hall-Element aus.

Die Erfindung betrifft somit ein integriertes Hall-Bauelement entsprechend dem Oberbegriff des Anspruchs 1.

Die der  Erfindung zugrundeliegende Aufgabe besteht darin,
die Empfindlichkeit eines solchen Hall-Bauelements weitgehend unabhängig von den Schwankungen der Herstellungsbedingungen zu machen, insbesondere von dem Flächenwiderstand
der Schicht des einen Leitungstyps, die epitaktisch aufgebracht werden kann.

Die Erfindung geht von dem Grundgedanken aus, den Hallstrom I zu stabilisieren und zu diesem Zweck eine Stromquellenschaltung mit einem strombestimmenden Widerstand zu verwenden, der bei einer Integration in einer solchen Weise von den Schwankungen der Herstellungsbedingungen des integrierten Hall-Bauelements abhängig ist, daß die Hallspannung $U_H$ weitgehend unabhängig von diesen Schwankungen ist. Solche Stromquellenschaltungen sind beispielsweise aus der Zeitschrift "Funktechnik" Nr. 10 (1975), Seiten 278 bis 311 bekannt. Bei solchen, innerhalb des integrierten Hall-Bauelements nach der Erfindung verwendbaren Stromquellenschaltungen fließt ein durch die Betriebsspannung $U_{CC}$ und einen Widerstand R bestimmter Strom durch einen als Diode geschalteten Transistor.

Die oben genannte Aufgabe wird unter Verwendung einer solchen Stromquellenschaltung erfindungsgemäß durch die im kennzeichnenden Teil des Anspruchs 1 angegebene Ausbildung gelöst.

Wird also Silicium als Material der Schicht verwendet, so muß der strombestimmende Widerstand R ebenfalls aus Silicium bestehen. Darüber hinaus muß er die gleiche Dotierung nicht nur hinsichtlich des Dotierungsmaterials, sondern auch hinsichtlich des Konzentrationsverlaufs aufweisen. Diese Bedingung ist ohne weiteres einzuhalten, wenn der Widerstand und der wirksame Bereiche des Hall-Elements gleichzeitig in bzw. an einem Substratkörper hergestellt werden.

Die Schicht des einen Leitungstyps kann bei der Herstellung des integrierten Hall-Bauelements nach der Erfindung nicht nur epitaktisch aufgebracht werden; sie kann auch durch einen Diffusionsprozeß in den Substratkörper oder in eine Substratschicht des anderen Leitungstyps eingebracht werden.

G. Schwabe - 6                    Fl 978

Eine einfache Ausführungsform des integrierten Hall-
Bauelements nach der Erfindung und deren Herstellung werden
im folgenden anhand der Zeichnung erläutert, deren

Fig. 1    eine einfache Stromquellenschaltung eines
          integrierten Hall-Bauelements nach der
          Erfindung bedeutet, deren

Fig. 2    in Aufsicht auf die Hauptfläche schematisch
          ein integriertes Hall-Bauelement nach der
          Erfindung zeigt, in der die Stromquellenschaltung gemäß der Fig. 1 verwendet wird,
          und deren

Fig. 3    einen Querschnitt entlang der Schnittlinie A-A

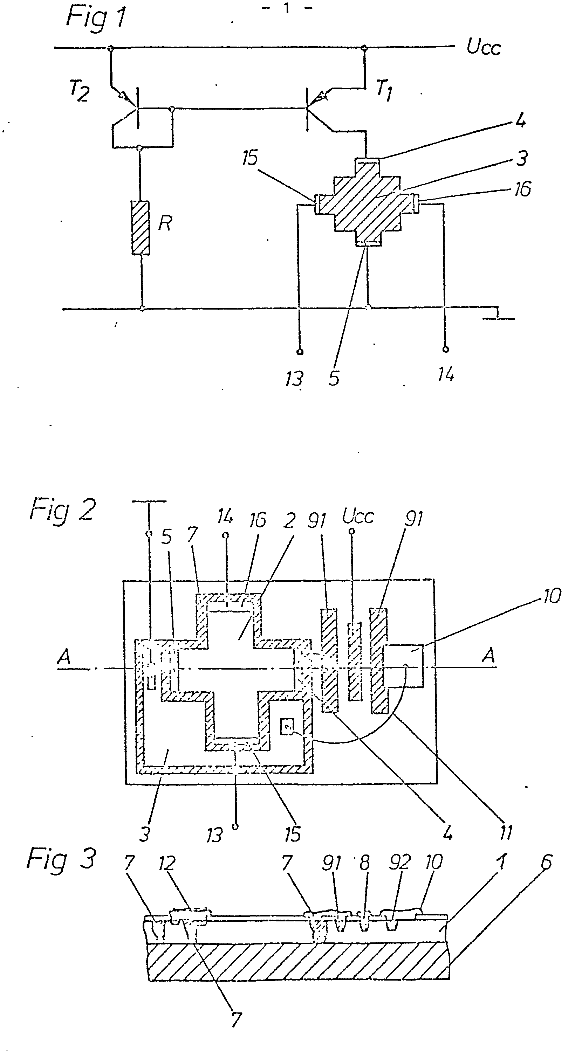

          der Fig. 2 bedeutet.

Die Fig. 1 zeigt eine Stromquellenschaltung, die den Stromquellentransistor T1, einen als Diode geschalteten Transistor T2 und den strombestimmenden Widerstand R enthält. In
Reihe zu den Stromeinspeisungskontakten 4 und 5, die sperrfrei am Halbleitermaterial des Hall-Elements angebracht
sind, ist die Emitter-Kollektor-Strecke des Stromquellentransistors T1 geschaltet. Dessen Basis ist mit der Basis
und dem Kollektor des Transistors T2 verbunden, so daß der
Transistor T2 als Diode geschaltet ist. Die beiden Emitter
der Transistoren T1 und T2 liegen an der Spannungsversorgung $U_{cc}$ mit positivem Potential gegenüber Masse, sofern
PNP-Transistoren wie im vorliegenden Ausführungsbeispiel
verwendet werden. Zwischen Masse und den Kollektor des als
Diode geschalteten Transistors T2 ist der strombestimmende
Widerstand R geschaltet. Dessen Widerstandswert bestimmt
den Strom, der durch den Transistor T2 fließt. Aufgrund der
bekannten Eigenschaften dieser Schaltung erscheint dieser Strom bei Realisierung dieser Schaltung in Form einer
monolithisch integrierten Schaltung wegen der guten Übereinstimmung beider Transistoren T1 und T2 "gespiegelt" auch
am Transistor T2.

Wird also der Widerstand R entsprechend der Lehre der Erfindung aus demselben Halbleitermaterial und mit derselben
Dotierung hergestellt wie das Halbleitermaterial 3 des Hall-
Elements, so werden sich die Schwankungen der Herstellungsbedingungen in gleicher Weise auf den Widerstand R und den
den Hallstrom I bestimmenden Widerstand des Halbleitermaterials 3 des Hall-Elements auswirken, so daß die Schwankungen der Hallspannung kompensiert sind.

Die Fig. 2 zeigt in Aufsicht schematisch ein integriertes
Hall-Bauelement nach der Erfindung, bei dem die Stromquellenschaltung gemäß der Fig. 1 verwendet wird. Die
Fig. 3 veranschaulicht den Schnitt entlang der Schnittlinie A-A der Fig. 2.

Das rechteckförmige Halbleiterplättchen gemäß der Fig. 2
weist eine n-dotierte Halbleiterschicht 1 auf, die auf
einem p-dotierten Substratkörper 6 epitaktisch aufgebracht
worden ist, wie die Fig. 3 veranschaulicht. In den Fig. 2
und 3 ist im übrigen das p-dotierte Halbleitermaterial
schraffiert dargestellt. Durch die epitaxial aufgebrachte
Schicht 1 wird die p-dotierte Isolierzonenstruktur 7 diffundiert, so daß drei getrennte Bereiche der Schicht 1 erhalten werden, nämlich der Bereich mit dem Halbleitermaterial 2 des Hall-Elements, der Bereich mit dem Widerstandsmaterial 3 des Widerstands R und der restliche Bereich,
in dem die p-dotierte Emitterzone 8 und zwei p-dotierte
Kollektorzonen 91 und 92 eines lateralen Zweifachkollektortransistors eingebracht worden sind. Die erste Kollektorzone 91 wird mit dem Kontakt 4 des Hall-Elements kontaktiert, während die zweite Kollektorzone 91 von einer beide
Gebiete überlappenden Metallschicht 10 kontaktiert wird,
welche den pn-Übergang zwischen der zweiten Kollektorzone 91
und der die Basiszone des lateralen Transistors bildenden
Schicht 1 kurzschließt und an dem das eine Ende des Widerstands R über den Leiter 11 gemäß der Fig. 2 angeschlossen
wird.

Das andere Ende des Widerstands R, der in Form des Bereichs 3 der epitaxial aufgebrachten Schicht 11 ausgebildet
ist, wird sowohl mit dem zweiten Kontakt 5 des Hall-Elements
als auch mit Masse verbunden, was gemäß der Fig. 3 mittels
einer Kontaktschicht 12 erfolgen kann, die außerdem die Isolierzonen 7 kontaktiert, so daß der Substratkörper 6 auf
das negativste Potential des integrierten Hall-Bauelements
gelegt ist.

Die Hallspannung $U_H$ wird an den Anschlußkontakten 13 und 14
der Fig. 1 und 2 abgegriffen, die mit den Hallspannungskontakten 15 und 16 kontaktiert sind.

Aufgrund der weitgehenden Unabhängigkeit der Hallspannungsempfindlichkeit von den fertigungsbedingten Herstellungsschwankungen kann die Hallempfindlichkeit des integrierten
Hall-Bauelements nach der Erfindung durch die Möglichkeit
einer voneinander unabhängigen Einstellung der Dotierungskonzentration n (spezifischer Schichtwiderstand) und I auf
große Werte eingestellt werden. Dies ist ein wesentlicher
Vorteil gegenüber herkömmlichen integrierten Hall-Bauelementen.

G. Schwabe - 6                                    Fl 978

## Patentansprüche

1. Integriertes Hall-Bauelement mit einem Hall-Element, welches aus einem Bereich einer Schicht des einen Leitungstyps auf einem plattenförmigen Substratkörper des anderen Leitungstyps besteht und sowohl ein Paar von Stromeinspeisungskontakten als auch ein Paar von Hallspannungskontakten aufweist, dadurch gekennzeichnet,

daß in Serie zu den Stromeinspeisungskontakten eine Stromquellenschaltung liegt, deren strombestimmender Widerstand (R) aus dem gleichen Halbleitermaterial mit der gleichen Dotierung besteht wie das Material des Hall-Elements.

2. Integriertes Hall-Bauelement nach Anspruch 1, dadurch gekennzeichnet, daß das Hall-Element aus einem ersten Bereich (2) einer Epitaxschicht (1) und der strombestimmende Widerstand (R) aus einem zweiten Bereich (3) der Epitaxschicht (1) bestehen.

0010125

Fig 1

$U_{CC}$

$T_2$    $T_1$

4

3

15

16

R

13   5   14

Fig 2

14   16   2   91   $U_{CC}$   91

5   7

A      A

10

3   13   15   4   11

Fig 3

7   12    7   91   8   92   10    1   6

7

Europäisches
Patentamt

# EUROPÄISCHER RECHERCHENBERICHT

Nummer der Anmeldung

0010125

EP 79 10 2810

## EINSCHLÄGIGE DOKUMENTE

| Kategorie | Kennzeichnung des Dokuments mit Angabe, soweit erforderlich, der maßgeblichen Teile | betrifft Anspruch |
|---|---|---|
| | US - A - 3 816 766 (SPRAGUE ELECTRIC)<br>* Spalte 1, Zeilen 25-68; Spalte 2, Zeilen 1-58 *<br><br>---- | 1,2 |

**KLASSIFIKATION DER ANMELDUNG (Int.Cl.³)**

H 01 L 27/22
43/06

**RECHERCHIERTE SACHGEBIETE (Int. Cl.³)**

H 01 L 27/22
43/06

**KATEGORIE DER GENANNTEN DOKUMENTE**

X: von besonderer Bedeutung
A: technologischer Hintergrund
O: nichtschriftliche Offenbarung
P: Zwischenliteratur
T: der Erfindung zugrunde liegende Theorien oder Grundsätze
E: kollidierende Anmeldung
D: in der Anmeldung angeführtes Dokument
L: aus andern Gründen angeführtes Dokument
&: Mitglied der gleichen Patentfamilie, übereinstimmendes Dokument

Der vorliegende Recherchenbericht wurde für alle Patentansprüche erstellt.

| Recherchenort | Abschlußdatum der Recherche | Prüfer |
|---|---|---|
| Den Haag | 25-01-1980 | HASLAUER |

EPA form 1503.1  06.78